# EUROPEAN PATENT SPECIFICATION

(11) **EP 0 281 753 B1**
(45) Date of publication and mention of the grant of the patent: **09.03.1994**
(21) Application number: 88101321.3
(22) Date of filing: 29.01.1988
(51) Int. Cl.: H01L 39/12, H01L 39/24, C04B 35/00, C01G 3/00

(54) **Electrically superconducting compositions and processes for their preparation**
Supraleitende Zusammensetzungen und Verfahren zu deren Herstellung
Compositions supraconductrices et leur procédé de fabrication

(30) Priority: 11.03.1987 US 24653
(43) Date of publication of application: 14.09.1988
(73) Proprietor: International Business Machines Corporation, Armonk, N.Y. 10504 (US)
(72) Inventor: Beyers, Robert Bruce, San Jose California 95120 (US); Engler, Edward Martin, San Jose California 95123 (US); Grant, Paul Michael, Morgan Hill California 95037 (US); Lim, Grace Su, San Jose California 95148 (US); Parkin, Stuart Stephen Papworth, San Jose California 95123 (US)
(74) Representative: Burt, Roger James, Dr.

(56) References cited:
- EP-A- 0 274 407
- WO-A-88/05029
- WO-A-88/05604
- PHYSICAL REVIEW LETTERS, vol. 58, no. 9, 2nd March 1987, pages 908-910; M.K. WU et al.: "Superconductivity at 93 K in a new mixed-phase Y-Ba-Cu-O compound system at ambient pressure"
- PRAMANA-J. PHYS., vol. 28, no. 3, March 1987, pages L321-L323, Bangalore, India; P. GANGULY et al.: "Identification of the high-temperature superconducting phase in the Y-Ba-Cu-O system as the perovskite YBa2Cu3O7+delta"
- PHYSICAL REVIEW LETTERS, vol. 58, no. 16, 20th April 1987, pages 1676-1679, The American Physical Society; R.J. CAVA et al.: "Bulk superconductivity at 91 K in single-phase oxygen-deficient perovskite Ba2YCu3O9-delta"
- J. AM. CHEM. SOCIETY, vol. 109, 29th April 1987, pages 2848-2849, American Chemical Society; E.M. ENGLER et al.: "Superconductivity above liquid nitrogen temperature: preparation and properties of a family of perovskite-based superconductors"
- M.K. WU et al., Physical Review Letters, 58, 908, 2 March 1987.

## Description

The present invention is concerned with electrically superconducting compositions which are useful at a temperature above 77K and with methods for the preparation of such compositions.

The technical breakthrough of Bednorz and Muller, Z Phys B, 64, 189 (1986), was the first major improvement in the superconducting transition temperature in the last decade. The material was of nominal composition La₂₋ₓMₓCuO_{y} where M=Ca, Ba or Sr, x was typically >0 and <0.3 and y was variable depending on preparation conditions. Superconductivity was found only over this narrow range of doping of M. The highest superconducting transition (Tc) was obtained for Sr doping and x equal to approximately 0.15 - 0.20 with Tc in the mid forty degree Kelvin range, Cava et al, Phys Rev Letters, 58, 408 (1987). Subsequently, it was reported in March 1987, Wu et al, Phys Rev Letters, 58, 908 (1987) that Y_{1.2}Ba_{0.8}CuO_{y} displayed the onset of superconductivity in the mid ninety degree Kelvin range. In contrast to the earlier work on La₂₋ₓMₓCuO_{y}, this higher temperature superconductor has been only prepared as a mixture of several unknown phases and only a minor fraction of the material actually goes superconducting. Experimentation has revealed that superconductivity is not a general phenomenon in this class of materials. Even minor composition variations or isoelectronic atom substitutions will not show superconductivity. For example, Sr or Ca substitution for Ba in Y_{1.2}Ba_{0.8}CuO_{y} did not produce superconductors.

It has now been discovered that compositions having the formula A_{1±x}M_{2±x}Cu₃O_{y}, wherein A is the metal Y, or a combination of Y, La, Lu, Sc or Yb, M is the metal Ba, or a combination of Ba, Sr or Ca, x is typically a value in the range from 0 to 0.5 and y is sufficient to satisfy the valence demands are single phase bulk electrical superconductors at a temperature above that of liquid nitrogen, namely 77K. The compositions have a perovskite-like crystalline structure, and retain an enhanced oxygen content as a result of employing a slow cooling stage of at least four hours in the presence of oxygen following a heating step during manufacture, whereby the single phase bulk electrical superconductor is formed. They are made by intimately mixing in the form of powders the metal oxides or precursors of metal oxides such as carbonates or hydroxides. The heating of the mixture is conducted at a temperature between about 800°C and about 1100°C in the presence of oxygen. The preferred temperature is about 900 to 1000°C. The heating is carried out for a period of time from about 10 to about 40 hours. In general, the lower the temperature, the longer the time required for heating. It is also a critical feature of the present invention that following the heating, the composition is slowly cooled to room temperature in the presence of oxygen over a period of at least four hours. Preferred compositions have formulas very close to A₁M₂Cu₃O_{y} wherein A is Y, or a combination of Y, La, Lu, Sc or Yb and M is Ba, or a combination of Ba, Sr or Ca and y is sufficient to satisfy the valence demands. The most preferred compositions are those in which A is Y and M is Ba. This most preferred composition exhibits single phase bulk electrical superconductivity at a temperature well above 77K. It has a perovskite-like crystalline structure and consists essentially of a metal compound having one atom of yttrium, two atoms of barium and three atoms of copper and a non-metal component of oxygen.

### Example

Oxides or carbonates of Y, Ba and Cu are thoroughly mixed or alternately their soluble nitrate or chloride compounds are coprecipitated as their hydroxide or carbonate salts. The mixed powders are heated in an oven at 800-1100 degrees C in either oxygen or air for periods ranging from 10-40 hours. (Oxygen gives better results.) Longer heating times ensure more homogeneous reaction of the starting compounds. Longer reaction times are required at the lower temperatures. To prepare rigid samples, the powders from the initial heating procedure are compressed into pellets or combined in polymeric binders and heated again under similar conditions. The use of an oxygen atmosphere when heating, and slow cooling of the oven to room temperature are important for realizing the sharpest and highest superconducting transitions, and more bulk superconductivity. Typically, the oven is cooled from 900-1000 degrees C over about 5 hours to room temperature.

The compositions obtained by the above process have a perovskite-like structure which can have variable oxygen content depending upon the final annealing and cooling steps. Removal of oxygen, for example, by heating in an inert or reducing atmosphere suppresses superconductivity. Higher oxygen content leads to improved and higher superconducting properties. As mentioned above, it is essential that following the heating step, the compositions be cooled slowly. It is believed that this slow cooling is required because when the material is cooled slowly, it retains slightly more oxygen than when it is cooled rapidly.

The following materials have all demonstrated bulk superconductivity at a temperature above 77°K. They are all single phase perovskite-like crystalline structures within the general formula A_{1±x}M_{2±x}Cu₃O_{y}.

The materials are:
(Y_{0.8}Lu_{0.2})_{1.0}Ba_{2.0}Cu₃O_{y}
(Y_{0.5}Lu_{0.5})_{1.0}Ba_{2.0}Cu₃O_{y}
(Y_{0.5}La_{0.5})_{1.0}Ba_{2.0}Cu₃O_{y}
(Y_{0.5}Sc_{0.5})_{1.0}Ba_{2.0}Cu₃O_{y}
(La_{0.5}Sc_{0.5})_{1.0}Ba_{2.0}Cu₃O_{y}
Y_{1.0}(Ba_{0.5}Ca_{0.5})_{2.0}Cu₃O_{y}
Y_{1.0}Sr_{0.5}Ca_{0.5})_{2.0}Cu₃O_{y}
Y_{0.8}Ba_{2.0}Cu₃O_{y}
Y_{1.2}Ba_{2.0}Cu₃O_{y}
Y_{1.0}Ba_{1.8}Cu₃O_{y}
Y_{1.0}Ba_{1.5}Cu₃O_{y}
Y_{1.2}Ba_{1.8}Cu₃O_{y}
All the above samples were confirmed to be superconductive by the AC magnetic susceptibility test method and by electrical resistivity measurements also.

To date, the following materials have not been found to be bulk single phase superconductors above 77°K when formulated and tested by the procedures described above:
Lu_{1.0}Ba_{2.0}Cu₃O_{y}
Lu_{1.0}Ca_{2.0}Cu₃O_{y}
La_{1.0}Ba_{2.0}Cu₃O_{y}
La_{1.0}Ca_{2.0}Cu₃O_{y}
Sc_{1.0}Ba_{2.0}Cu₃O_{y}
Y_{1.0}Ca_{2.0}Cu₃O_{y}
Y_{1.0}Ba_{1.0}Cu_{2.0}O_{y}
Y_{2.0}Ba_{1.0}Cu_{1.0}O_{y}
Perhaps it is necessary that either yttrium be most of the A component, or that the combination of two or more related A components have an average atomic size approximately that of yttrium.

The range of compositions are not exactly defined as whole number atomic ratios of A and M because it seems that the crystalline structure can accommodate vacancies of these metals and still retain the necessary structure for the high temperature superconductivity. In these cases, as in all others, the oxygen is present in an amount to satisfy the valence demands.

There are a wide variety of current uses of superconductivity at liquid helium temperatures which will be cheaper and more convenient to use at liquid nitrogen temperatures. The use of thin film and ceramic processing technologies will enable these materials to find applications in microelectronics, high field magnetics, energy transmission, and electromechanical devices. In particular, these materials are useful in logic devices in computers (for example Josephson logic devices) and for interconnect metallurgy on and between chips as a means of improving speed and packaging density.

## Claims

1. A composition which is a bulk electrical superconductor at a temperature above 77K, said composition having a perovskite-like crystalline structure and having the formula A_{1±x}M_{2±x}Cu₃O_{y} wherein A is the metal Y, or a combination of Y, La, Lu, Sc or Yb; M is the metal Ba, or a combination of Ba, Sr or Ca; x is a value in the range from 0 to 0.5 and y is sufficient to satisfy the valence demands, said composition retaining an enhanced oxygen content as a result of employing a slow cooling stage of at least four hours in the presence of oxygen following a heating step during manufacture, whereby a single phase bulk electrical superconductor is formed.

2. A composition as claimed in claim 1, wherein 'x' is zero.

3. A composition as claimed in claim 2, wherein A is Y, and M is Ba.

4. A process of making a single phase bulk electrical superconductor at a temperature above 77K having the composition A_{1±x}M_{2±x}Cu₃O_{y} wherein A is the metal Y, or a combination of Y, La, Lu, Sc or Yb; M is the metal Ba, or a combination of Ba, Sr or Ca; x is between 0 and 0.5 and y is sufficient to satisfy the valence demands, the process comprising the steps of:
1) intimately mixing in the form of powders oxides of said metals or precursors of said oxides,
2) heating the mixture to a temperature between about 800°C and about 1100°C in the presence of oxygen,
3) slowly cooling the mixture to room temperature in the presence of oxygen over a period of at least four hours.

5. A process as claimed in claim 4 wherein x is zero.

6. A process as claimed in claim 5, wherein the powders which are intimately mixed are yttrium oxide (Y₂O₃) or a precursor thereof, barium oxide (BaO) or a precursor thereof and cupric oxide (CuO) or a precursor thereof, in the mole ratio of 0.5 : 2 : 3.

7. A process as claimed in any of claims 4, 5 or 6 wherein the temperature of the heating is between 900°C and 950°C.

8. A process as claimed in any of claims 4, 5 or 6 wherein the time of the heating is between 10 hours and 40 hours.

9. A process as claimed in any of claims 4, 5 or 6 wherein the cooling takes place over a period of from 5 to 10 hours.

## Patentansprüche

1. Eine Zusammensetzung, die ein elektrischer Supraleiter bei einer Temperatur oberhalb von 77 K ist, wobei die Zusammensetzung eine perowskit-ähnliche kristalline Struktur aufweist und die Formel A_{1±x}M_{2±x}Cu₃O_{y} hat, wobei A das Metall Y oder eine Kombination aus Y, Sa, Lu, Sc oder Yb, M das Metall Ba oder eine Kombination aus Ba, Sr oder Ca, x normalerweise ein Wert zwischen 0 und 0,5 ist, und y ausreicht, um den Valenzanforderungen zu genügen, wobei die Zusammensetzung als Ergebnis der Anwendung einer langsamen Abkühlphase von mindestens 4-stündiger Dauer im Beisein von Sauerstoff nach einem Erhitzungsablauf während der Herstellung einen erhöhten Sauerstoffgehalt aufweist, wobei ein einphasiger elektrischer Supraleiter gebildet wird.

2. Eine Zusammensetzung gemäß Anspruch 1, wobei 'x' gleich Null ist.

3. Eine Zusammensetzung gemäß Anspruch 2, wobei A gleich Y und M gleich Ba ist.

4. Ein Verfahren zur Herstellung eines einphasigen elektrischen Supraleiters bei einer Temperatur oberhalb von 77 K, wobei die Zusammensetzung die Formel A_{1±x}M_{2±x}Cu₃O_{y} hat, wobei A das Metall Y oder eine Kombination aus Y, La, Lu, Sc oder Yb, M das Metall Ba oder eine Kombination aus Ba, Sr oder Ca, x normalerweise ein Wert zwischen 0 und 0,5 ist, und y ausreicht, um den Valenzanforderungen zu genügen, wobei das Verfahren folgende Schritte aufweist:
1) das gleichmäßige Mischen von Oxiden dieser Metalle oder Zwischenstufen dieser Metalle in Pulverform,
2) das Erhitzen der Mischung auf eine Temperatur zwischen ungefähr 800°C und ungefähr 1100°C in Anwesenheit von Sauerstoff,
3) das langsame Abkühlen der Mischung auf Raumtemperatur im Beisein von Sauerstoff in einem Zeitraum von mindestens vier Stunden.

5. Ein Verfahren gemäß Anspruch 4, wobei x gleich Null ist.

6. Ein Verfahren gemäß Anspruch 5, wobei es sich bei den gleichmäßig gemischten Pulvern um Yttriumoxid (Y₂O₃) oder einer Zwischenstufe davon, Bariumoxid (BaO) oder einer Zwischenstufe davon und Kupferoxid (CuO) oder einer Zwischenstufe davon im Molverhältnis von 0,5 : 2 : 3 handelt.

7. Ein Verfahren gemäß den Ansprüchen 4, 5 oder 6, wobei die Erhitzungstemperatur zwischen 900°C und 950°C liegt.

8. Ein Verfahren gemäß den Ansprüchen 4, 5 oder 6, wobei die Erhitzungsdauer zwischen 10 Stunden und 40 Stunden beträgt.

9. Ein Verfahren gemäß den Ansprüchen 4, 5 oder 6, wobei sich die Abkühlung über einen Zeitraum von 5 bis 10 Stunden erstreckt.

## Revendications

1. Composition constituée d'un supraconducteur électrique en masse à une température supérieure à 77K, ladite composition ayant une structure cristalline du genre perovskite et présentant la formule A_{1±x}M_{2±x}Cu₃O_{y} où A est le métal Y, ou une combinaison de Y, La, Lu, Sc ou Yb ; M est le métal Ba, ou une combinaison de Ba, Sr ou Ca ; x est une valeur dans une plage de 0 à 0,5 et y est suffisant pour satisfaire les exigences de valence, ladite composition retenant et augmentant le contenu en oxygène suite à l'emploi d'une étape de refroidissement lent d'au moins quatre heures en présence d'oxygène faisant suite à une étape de chauffage pendant la fabrication, de sorte qu'un supraconducteur électrique en masse à phase unique est formé.

2. Composition selon la revendication 1, dans laquelle "x" est égal à zéro.

3. Composition selon la revendication 2, dans laquelle A est égal à Y, et M est Ba.

4. Procédé de fabrication d'un supraconducteur électrique à phase unique en masse à une température supérieure à 77K ayant la composition A_{1±x}M_{2±x}Cu₃O_{y} dans laquelle A est le métal Y, ou une combinaison de Y, La, Lu, Sc ou Yb ; M est le métal Ba, ou une combinaison de Ba, Sr ou Ca ; x est une valeur dans une plage de 0 à 0,5 et y est suffisant pour satisfaire les exigences de valence, ce procédé comprenant les étapes consistant à :
1) mélanger intimement dans la forme de poudres d'oxydes desdits métaux ou précurseurs desdits oxydes,
2) chauffer la mixture à une température entre environ 800°C et environ 1100°C en présence d'oxygène,
3) refroidir lentement la mixture jusqu'à température ambiante en présente d'oxygène pendant une période d'au moins quatre heures.

5. Procédé selon la revendication 4, dans lequel x est égal à zéro.

6. Procédé selon la revendication 5, dans lequel les poudres qui sont intimement mélangées sont l'oxyde d'yttrium (Y₂O₃) ou un précurseur de celui-ci, l'oxyde de baryum (BaO) ou un précurseur de celui-ci et l'oxyde cuprique (CuO) ou un précurseur de celui-ci, dans le rapport molaire de 0,5 : 2 : 3.

7. Procédé selon l'une quelconque des revendications 4, 5 ou 6, dans lequel la température de chauffage est comprise entre 900°C et 950°C.

8. Procédé selon l'une quelconque des revendications 4, 5 ou 6, dans lequel la durée du chauffage est entre 10 heures et 40 heures.

9. Procédé selon l'une quelconque des revendications 4, 5 ou 6, dans lequel le refroidissement a lieu pendant une durée comprise entre 5 à 10 heures.
